# EUROPEAN PATENT SPECIFICATION

(11) **EP 0 594 242 B1**
(45) Date of publication and mention of the grant of the patent: **21.07.1999**
(21) Application number: 93202872.3
(22) Date of filing: 12.10.1993
(51) Int. Cl.: G11C 27/02

(54) **Sample-and-hold circuit with reduced clock feedthrough**
Abtast-und Halteschaltung mit Reduktion des Taktdurchgriffs
Circuit d'échantillonnage et de maintien avec réduction de traversée d'horloge

(30) Priority: 19.10.1992 EP 92203190
(43) Date of publication of application: 27.04.1994
(73) Proprietor: Koninklijke Philips Electronics N.V., 5621 BA Eindhoven (NL)
(72) Inventor: Rijns, Johannes J.F., c/o INT. OCTROOIBUREAU B.V., NL-5656 AA Eindhoven (NL)
(74) Representative: Groenendaal, Antonius Wilhelmus Maria

(56) References cited:
- GB-A- 2 069 267
- US-A- 4 352 070
- MICROELECTRONICS AND RELIABILITY, vol.16, no.1, 1977, OXFORD GB pages 57 - 67 HAYNES 'NEW ANALOGUE COMPONENT CONCEPTS FOR DIGITAL PROCESSINGS SYSTEMS'
- ELECTRONIC ENGINEERING, vol.57, no.703, July 1985, LONDON GB page 25 'DUAL JFETS IMPROVE INTEGRATE/HOLD CIRCUIT'

## Description

The invention relates to a sample-and-hold circuit comprising:
- an input terminal for the application of an input signal to be sampled,
- a first buffer stage having an input coupled to the input terminal, and having an output,
- a first switching element having a control electrode coupled to a clock signal terminal for the application of a clock signal, having a first main electrode coupled to the output of the first buffer stage, and having a second main electrode,
- a first capacitive impedance having a first terminal coupled to the second main electrode of the first switching element, and having a second terminal coupled to a point of fixed potential,
- an output amplifier having a non-inverting input coupled to the first terminal of the first capacitive impedance, having an inverting input, and having an output coupled to an output terminal for supplying a sampled output signal,
- a second switching element having a control electrode coupled to the clock signal terminal, having a first main electrode coupled to the output of the output amplifier, and having a second main electrode coupled to the inverting input of the output amplifier, and
- a second capacitive impedance having a first terminal coupled to the second main electrode of the second switching element and having a second terminal coupled to the output of the output amplifier.

Sample-and-hold circuits, also referred to as track-and-hold circuits, are frequently used as interface circuits from the time-continuous domain to the time-discrete domain and *vice versa*. Examples can be found in analog-to-digital converters and digital-to-analog converters and in switched capacitor circuits.

A sample-and-hold circuit of the type defined in the opening paragraph is known *inter alia* from Japanese Patent Publication JP 55-8656 (A). The input signal to be sampled is buffered by the first buffer stage, which charges the first capacitive impedance to the instantaneous value of the input signal when the first switch element is turned on. The output amplifier is arranged as a voltage follower and serves as a buffer between the first capacitive impedance and the output terminal. The output amplifier receives negative feedback by means of the second switching element and the second capacitive impedance, which are arranged in parallel between the output and the inverting input.

When the first switching element is conductive the output signal is a scaled replica of the input signal, the input signal being subjected to a filtering process which is dependent on the impedances of the first switching element and on the first capacitive impedance. When the first switching element is turned off charge carriers are injected towards the impedances connected to the first and the second main electrode of the first switching element. This injection produces an undesired voltage step across the first capacitive impedance, which step also appears in the output signal. This effect is known as clock feedthrough. Said voltage step is counteracted by means of the second switching element and the second capacitive impedance in the negative-feedback path of the output amplifier. These elements produce a voltage step at the inverting input, which serves to compensate for the voltage step produced at the non-inverting input by the first semiconductor switch. However, this compensation is not perfect because the impedances connected to the first and second main electrodes of the first and the second switching element are not entirely equal to one another. Therefore, the attainable reduction of the clock feedthrough is liable to improvement.

It is an object of the invention to provide a sample-and-hold circuit having a clock feedthrough which is reduced even further. To achieve this, in accordance with the invention, the sample-and-hold circuit of the type defined in the opening paragraph is characterized in that the sample-and-hold circuit further comprises:
- a second buffer stage having an input coupled to the point of fixed potential and having an output coupled to the second terminal of the first capacitive impedance,
- a third buffer stage having an input coupled to the output of the output amplifier, and having an output coupled to the first main electrode of the second switching element, and
- a fourth buffer stage having an input coupled to the output of the output amplifier, and having an output coupled to the second terminal of the second capacitive impedance, and
in that the first (6) and the third (40) buffer stage are substantially identical, the first (10) and the second (44) switching element are substantially identical, the first (16) and the second (48) capacitive impedance are substantially identical, and the second (22) and the fourth (54) buffer stage are substantially identical.

By adding the second, the third and the fourth buffer stage it is achieved that the impedances connected to the first and the second switching element are substantially equal to one another. This results in an improved symmetry and a corresponding reduction of the clock feedthrough. An additional advantage of the chosen solution is that the buffers may be very simple and may even have an offset from input to output. The offsets will cancel one another owing to the symmetry of the circuit.

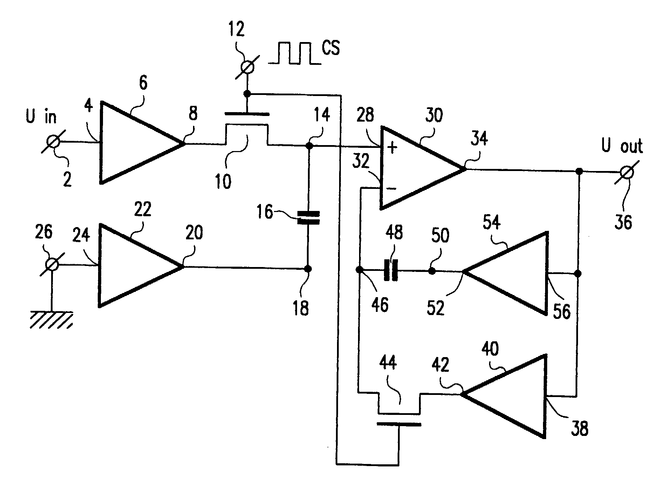

The invention will be described and elucidated with reference to the accompanying drawing, in which the single Figure shows a sample-and-hold circuit in accordance with the invention.

The Figure shows a sample-and-hold circuit in accordance with the invention. An input signal Uin to be sampled is applied to an input terminal 2, which is connected to an input 4 of a buffer stage 6 having an output 8 connected to a first main electrode of a switching element 10, which is for example a MOS transistor. The control electrode or gate of the switching element 10 is connected to a clock signal terminal 12, to which a clock signal CS is applied. A second main electrode of the switching element 10 is connected to a first terminal 14 of a capacitive impedance 16, which has a second terminal 18 connected to an output 20 of a buffer stage 22, which has an input 24 connected to a point 26 of fixed potential. In the present case the point 26 is connected to earth, so that in effect the terminal 18 of the capacitive impedance 16 is also connected to earth. Moreover, the terminal 14 is connected to a non-inverting input 28 of an output amplifier 30, which further has an inverting input 32 and an output 34, which output is connected to an output terminal 36 for supplying a sampled output signal Uout. The output 34 is connected to an input 38 of a buffer stage 40, which has an output 42 connected to a first main electrode of a switching element 44, for which again a MOS transistor has been selected. The control electrode or gate of the switching element 44 is also connected to the clock signal terminal 12, but separate control with another clock signal is also possible. The second main electrode of the switching element 44 is connected to the inverting input 32 of the output amplifier 30 and to a first terminal 46 of a capacitive impedance 48, which has a second terminal 50 connected to an output 52 of a buffer stage 54. The buffer stage 54 has an input 56 connected to the output 34 of the output amplifier 30.

The two switching elements 10 and 44 are energized from and loaded with equal impedances if the buffer stages 6, 22, 40 and 54 are identical and if the capacitive impedances 16 and 48 are identical. If the switching elements 10 and 44 are now also identical this will result in identical charge injections at the terminals 14 and 46 when these switches are turned off. The voltage step as a result of this charge injection appears both at the non-inverting input 28 and at the inverting input 32 of the output amplifier 30 and does not occur in the output signal Uout owing to the common-mode rejection of the output amplifier 30.

If the two switching elements 10 and 44 are conductive, *i.e.* in the sampling phase, the capacitive impedance 16 will be charged. The output amplifier 30 is arranged as a voltage follower *via* the buffer stage 40 and the switching element 44. In the hold phase both switching elements 10 and 44 are cut off. The output amplifier 30 then also operates as a follower because the voltage difference built up between the output 34 and the inverting input in the sampling phase is maintained constant by the buffer stage 54 and the capacitive impedance 48. During the change from the sampling phase to the hold phase the voltage steps appearing at the terminals 14 and 46 as a result of the charge injection cancel one another. Cancellation is achieved not only if all the buffer stages are identical to one another but also if the two buffer stages 6 and 40 are identical to each other and the two buffer stages 22 and 54 are identical to each other.

The capacitive impedances 16 and 48 are preferably capacitors but may also comprise a more complex impedance with a substantially capacitive behaviour. The switching elements 10 and 44 may be formed by PMOS or NMOS transistors or by a parallel arrangement of a PMOS and an NMOS transistor. Bipolar switching transistors are also possible because these transistors produce a similar charge injection as MOS transistors. In fact, any controllable switching element may be used. The balanced structure of the circuit will cancel the clock feedthrough produced by the switching elements.

If desired, very simple bipolar emitter followers or unipolar source followers may be used as buffer stages without this leading to an undesirable offset between the input terminal 2 and the output terminal 36. Indeed, the symmetry of the sample-and-hold circuit in accordance with the invention ensures that the offset between the base and emitter or between the gate and source of these simple buffer stages will be cancelled.

## Claims

1. A sample-and-hold circuit comprising:
- an input terminal (2) for the application of an input signal (Uin) to be sampled,
- a first buffer stage (6) having an input (4) coupled to the input terminal (2), and having an output (8),
- a first switching element (10) having a control electrode coupled to a clock signal terminal (12) for the application of a clock signal (CS), having a first main electrode coupled to the output (8) of the first buffer stage (6), and having a second main electrode,
- a first capacitive impedance (16) having a first terminal (14) coupled to the second main electrode of the first switching element (10), and having a second terminal (18) coupled to a point of fixed potential (26),
- an output amplifier (30) having a non-inverting input (28) coupled to the first terminal (14) of the first capacitive impedance (16), having an inverting input (32), and having an output (34) coupled to an output terminal (36) for supplying a sampled output signal (Uout),
- a second switching element (44) having a control electrode coupled to the clock signal terminal (12), having a first main electrode coupled to the output (34) of the output amplifier (30), and having a second main electrode coupled to the inverting input (32) of the output amplifier (30), and
- a second capacitive impedance (48) having a first terminal (46) coupled to the second main electrode of the second switching element (44) and having a second terminal (50) coupled to the output (34) of the output amplifier (30), characterized in that the sample-and-hold circuit further comprises:
- a second buffer stage (22) having an input (24) coupled to the point of fixed potential (26) and having an output (20) coupled to the second terminal (18) of the first capacitive impedance (16),
- a third buffer stage (40) having an input (38) coupled to the output (34) of the output amplifier (30), and having an output (42) coupled to the first main electrode of the second switching element (44), and
- a fourth buffer stage (54) having an input (56) coupled to the output (34) of the output amplifier (30), and having an output (52) coupled to the second terminal (50) of the second capacitive impedance (48), and
in that the first (6) and the third (40) buffer stage are substantially identical, the first (10) and the second (44) switching element are substantially identical, the first (16) and the second (48) capacitive impedance are substantially identical, and the second (22) and the fourth (54) buffer stage are substantially identical.

2. A sample-and-hold circuit as claimed in Claim 1, characterized in that the first through the fourth buffer stage (6, 22, 40, 54) are substantially identical to one another.

## Patentansprüche

1. Abtast-Halteschaltung mit:
- einer Eingangsklemme (2) zum Anlegen eines abzutastenden Eingangssignals (Uin),
- einer ersten Pufferstufe (6) mit einem mit der Eingangsklemme (2) gekoppelten Eingang (4) und mit einem Ausgang (8),
- einem ersten Schaltelement (10) mit einer mit einer Taktsignalklemme (12) gekoppelten Steuerelektrode zum Anlegen eines Taktsignals (CS), mit einer ersten mit dem Ausgang (8) der ersten Pufferstufe (6) gekoppelten Hauptelektrode und mit einer zweiten Hauptelektrode,
- einer ersten kapazitiven Impedanz (16) mit einer mit der zweiten Hauptelektrode des ersten Schaltelements (10) gekoppelten ersten Klemme (14) und mit einer mit einem Punkt festen Potentials (26) gekoppelten zweiten Klemme (18),
- einem Ausgangsverstärker (30) mit einem mit der ersten Klemme (14) der ersten kapazitiven Impedanz (16) gekoppelten nichtinvertierenden Eingang (28), mit einem invertierenden Eingang (32) und mit einem mit einer Ausgangsklemme (36) gekoppelten Ausgang (34) zum Liefern eines abgetasteten Ausgangssignals (Uout),
- einem zweiten Schaltelement (44) mit einer mit der Taktsignalklemme (12) gekoppelten Steuerelektrode, mit einer mit dem Ausgang (34) des Ausgangsverstärkers (30) gekoppelten ersten Hauptelektrode und mit einer mit dem invertierenden Eingang (32) des Ausgangsverstärkers (30) gekoppelten zweiten Hauptelektrode und
- einer zweiten kapazitiven Impedanz (48) mit einer mit der zweiten Hauptelektrode des zweiten Schaltelements (44) gekoppelten ersten Klemme (46) und mit einer mit dem Ausgang (34) des Ausgangsverstärkers (30) gekoppelten zweiten Klemme (50),
dadurch gekennzeichnet, dass die Abtast-Halteschaltung weiterhin umfasst:
- eine zweite Pufferstufe (22) mit einem mit dem Punkt festen Potentials (26) gekoppelten Eingang (24) und mit einem mit der zweiten Klemme (18) der ersten kapazitiven Impedanz (16) gekoppelten Ausgang (20),
- eine dritte Pufferstufe (40) mit einem mit dem Ausgang (34) des Ausgangsverstärkers (30) gekoppelten Eingang (38) und mit einem mit der ersten Hauptelektrode des zweiten Schaltelements (44) gekoppelten Ausgang (42) und
- eine vierte Pufferstufe (54) mit einem mit dem Ausgang (34) des Ausgangsverstärkers (30) gekoppelten Eingang (56), und mit einem mit der zweiten Klemme (50) der zweiten kapazitiven Impedanz (48) gekoppelten Ausgang (52) und
dass die erste (6) und die dritte (40) Pufferstufe nahezu identisch sind, das erste (10) und das zweite (44) Schaltelement nahezu identisch sind, die erste (16) und die zweite (48) kapazitive Impedanz nahezu identisch sind und die zweite (22) und die vierte (54) Pufferstufe nahezu identisch sind.

2. Abtast-Halteschaltung nach Anspruch 1, dadurch gekennzeichnet, dass die erste bis vierte Pufferstufe (6, 22, 40, 54) zueinander nahezu identisch sind.

## Revendications

1. Circuit d'échantillonnage et de maintien comportant:
- une borne d'entrée (2) pour l'application d'un signal d'entrée (Uin) à échantillonner,
- un premier étage tampon (6) ayant une entrée (4) couplée à la borne d'entrée (2) et présentant une sortie (8),
- un premier élément commutateur (10) ayant une électrode de commande couplée à une borne de signal d'horloge (12) pour l'application d'un signal d'horloge (CS), ayant une première électrode principale couplée à la sortie (8) du premier étage tampon (6) et présentant une deuxième électrode principale,
- une première impédance capacitive (16) ayant une première borne (14) couplée à la deuxième électrode principale du premier élément commutateur (10) et ayant une deuxième borne (18) couplée à un point de potentiel fixe (26),
- un amplificateur de sortie (30) ayant une entrée non inverseuse (28) couplée à la première borne (14) de la première impédance capacitive (16), présentant une entrée inverseuse (32) et ayant une sortie (34) couplée à une borne de sortie (36) pour délivrer un signal de sortie échantillonné (Uout),
- un deuxième élément commutateur (44) ayant une électrode de commande couplée à la borne de signal d'horloge (12), ayant une première électrode principale couplée à la sortie (34) de l'amplificateur de sortie (30) et ayant une deuxième électrode principale couplée à l'entrée inverseuse (32) de l'amplificateur de sortie (30), et
- une deuxième impédance capacitive (48) ayant une première borne (46) couplée à la deuxième électrode principale du deuxième élément commutateur (44) et ayant une deuxième borne (50) couplée à la sortie (34) de l'amplificateur de sortie (30), caractérisé en ce que le circuit d'échantillonnage et de maintien comporte encore:
- un deuxième étage tampon (22) ayant une entrée (24) couplée au point de potentiel fixe (26) et ayant une sortie (20) couplée à la deuxième borne (18) de la première impédance capacitive (16),
- un troisième étage tampon (40) ayant une entrée (38) couplée à la sortie (34) de l'amplificateur de sortie (30) et ayant une sortie (42) couplée à la première électrode principale du deuxième élément commutateur (44), et
- un quatrième étage tampon (54) ayant une entrée (56) couplée à la sortie (34) de l'amplificateur de sortie (30) et ayant une sortie (52) couplée à la deuxième borne (50) de la deuxième impédance capacitive (48), et en ce que les premier (6) et troisième (40) étages tampons sont sensiblement identiques, en ce que les premier (10) et deuxième (44) éléments commutateurs sont sensiblement identiques, en ce que les première (16) et deuxième (48) impédances capacitives sont sensiblement identiques et en ce que les deuxième (22) et quatrième (54) étages tampons sont sensiblement identiques.

2. Circuit d'échantillonnage et de maintien selon la revendication 1, caractérisé en ce que le premier jusqu'au quatrième étage tampon (6, 22, 40, 54) sont sensiblement identiques.
